# EUROPEAN PATENT APPLICATION

(11) **EP 4 567 858 A1**
(43) Date of publication of application: **11.06.2025**
(21) Application number: 23215101.9
(22) Date of filing: 07.12.2023
(51) Int. Cl.: H01J 37/20, G02B 21/26, F25D 19/00

(54) **SCIENTIFIC INSTRUMENT WITH CRYOGENIC SAMPLE STAGE**

(71) Applicant: FEI Company, Hillsboro, OR 97124 (US)
(72) Inventor: VASKE, Frantisek, Mikulov (CZ); MUSIL, Jan, Brno (CZ)
(74) Representative: Korenberg, Alexander Tal

(57) **Abstract**

A scientific instrument, for example an electron microscope, is disclosed and comprises a moveable stage with a sample holder. A cold finger is in contact with a heat sink and comprises a cooling plate configured to contact the sample holder to cool the sample holder in a rapid cooling position. A thermally conductive flexible member thermally connects the sample holder and the cold finger to cool the sample holder away from the rapid cooling position, where the sample can be investigated, imaged, and the like. Embodiments are disclosed in which both the cold and the sample holder move or in which only the cold finger move between a rapid cooling and other configurations. Also disclosed is a corresponding method for operating the scientific instrument. The disclosure advantageously combines rapid cooling in the rapid cooling position with reduced limitation of movement of the sample holder away from the parked position.

## Description

### TECHNICAL FIELD

This disclosure relates to a scientific instrument with a cooled sample stage, a method of cooling a sample, in particular although not exclusively in the context of cryogenic cooling of the sample for scientific investigations or imaging.

### BACKGROUND

Electron microscopes and other scientific instruments may include a cooled moveable sample stage for holding and cooling a sample, for example to investigate low temperature behaviour of the sample or protect the sample from radiation damage. In some known arrangements, the sample stage is connected to heatsink, for example a liquid nitrogen filled Dewar via a flexible copper braid or foil that is flexible enough to allow movement of the sample stage while still providing a sufficient rate of cooling. The flexibility of the braid or foil and the rate of cooling that can be achieved represent conflicting design requirements, because a high rate of heat transfer typically requires a thick and hence relatively stiff braid or foil.

### SUMMARY

The inventor has realised that the conflicting design requirements associated with a moveable cooled sample stage can be addressed by decoupling an initial cooling phase from maintaining the cooled temperature. This is achieved providing high heat transfer rate mediated by a cooling plate in contact with the sample stage in a parked position of a sample stage until a desired target temperature is reached. Subsequently, the target temperature can be maintained at a lower heat transfer rate via a flexible heat transfer connection, such as relative thin copper braid, once the sample stage leaves the parked position. The flexible heat transfer connection can consequently be specified to provide sufficient heat transfer to maintain the target temperature while being relatively more flexible to facilitate movement of the sample stage, for example thinner, compared to a flexible heat transfer connection that would be specified to provide the high heat transfer rate for the initial cooling.

In a first aspect, a scientific instrument for investigating a sample comprises a moveable stage. The moveable stage comprises a sample holder. The sample holder may hold a sample. A cold finger is in contact with a heat sink and comprises a cooling plate configured to contact the sample holder to cool the sample holder through the cooling plate when the moveable stage is disposed in a parked position. To cool the sample holder, the cooling plate may contact the sample holder in any suitable way, for example by direct mechanical contact between the cooling plate and sample holder. A thermally conductive flexible member, for example a conductive braid, such as a copper braid, thermally connects the sample holder and the cold finger to cool the sample holder through the thermally conductive flexible member when the moveable stage is disposed at a position away from the parked position, for example in a position where the sample can be investigated, imaged, and the like.

The moveable stage may be disposed in a sample chamber, for example a vacuum chamber.

The scientific instrument may be a microscope, for example a light microscope or a charged particle beam microscope, such as an electron microscope, and the sample holder may be moveable to an imaging position away from the parked position. The scientific instrument may thus comprise a beam source, for example a charged particle beam source, configured to emit a beam towards the sample holder in the imaging position, and a beam detector configured to receive a transmitted or reflected beam from the sample holder in the imaging position.

The scientific instrument may comprise a controller configured to move the moveable stage to a parked position with the sample holder in contact with the cooling plate; monitor a temperature of the sample holder while the moveable stage is in the parked position; and, in response to the temperature reaching a target temperature, move the moveable stage to a position away from the parked position, for example an imaging or other investigating position, for investigation, for example imaging, of the sample. The temperature may be monitored by any suitable means, such as a thermocouple or contactless infrared probe, and may be done by measuring the temperature directly or by measuring a temperature indicative of the temperature of the sample holder, for example the temperature of the sample.

The cooling plate may be resiliently mounted on the cold finger to facilitate close contact with the sample holder in a range of orientations. The cooling plate may be mounted using any resilient mount, for example one or more springs or the like. Heat transfer to the cooling plate may be through the mount alone, through a separate thermal connection or both. The separate thermal connection may be a relatively thick thermal braid (as compared to the thermally conductive flexible member) or any other suitably deformable resilient heat conductor. The resilient mount may be provided by a resilient deformable plate or other resiliently deformable member of a copper alloy or other suitably resilient alloy or other material.

The moveable stage may comprise a base connected to a motorised mechanism for moving the moveable stage. The sample holder may be mounted to the base by a thermally insulating member. The cooling plate may comprise an aperture to accommodate the insulating member. The cooling plate may additionally comprise a cooling face to contact a face of the sample holder facing the base.

The heat sink may comprise a Dewar to contain a cooling fluid. The Dewar may be disposed outside the sample chamber and the cold finger extends from inside the Dewar into the sample chamber.

In a further aspect, a method of cooling a sample disposed on a sample holder thermally connected to a cold finger by a thermally conductive flexible member is disclosed. The method comprises moving the sample holder to directly contact the cold finger to cool the sample on the sample holder at a first rate of cooling; monitoring a temperature of the sample holder; and, in response to the temperature reaching a target temperature, moving the sample holder away from the cold finger while continuing to cool the sample using the thermally conductive flexible member at a second rate of cooling lower than the first rate of cooling. More generally, additionally or instead of moving the sample holder, the cold finger may be moved, the relative movement selectively disposing the sample holder and cold finger in a first configuration for cooling by direct mechanical contact between the cold finger and the sample holder or in an investigation configuration, in which cooling occurs through the flexible member. Subsequent to moving the sample holder away from the cold finger, the method may comprise investigating the sample while keeping the sample holder at the target temperature. Investigating the sample may include any form of interaction with the sample to find out a characteristic of the sample, for example irradiating the sample with a beam, imaging the sample, for example using a charged particle beam such as an electron beam, and the like. The sample holder, cold finger and thermally conductive flexible member may be configured as described above.

In yet a further aspect, a scientific instrument comprises means for causing relative movement of a cold finger connected to a heat sink and a sample holder for holding a sample to move the scientific instrument between a first configuration in which the sample holder can be cooled through direct mechanical contact with the cold finger at a first rate of cooling and a second configuration for investigating the sample in which the cold finger and sample holder are not in direct mechanical contact and the sample holder is cooled at a second rate of cooling, lower than the first rate of cooling, through a flexible heat transfer connection between the cold finger and the sample holder, the flexible hear transfer connection accommodating the relative movement between the cold finger and the sample holder. Advantageously, by cooling at the higher, first rate in direct mechanical contact with the cold finger, the sample can be brought to temperature quickly, and cooling at the second rate in the second configuration can be sufficient for maintaining the sample temperature while allowing the flexible heat transfer connection to be sufficiently flexible, for example sufficiently thin, so as not to interfere with movement of the sample holder.

### BRIEF DESCRIPTION OF THE DRAWINGS

Disclosed implementations will now be described by way of example to illustrate aspects of the disclosure and with reference to the accompanying drawings, in which:
Figure 1 illustrates a scientific instrument with a cooling arrangement in a cross-sectional view;
Figure 2 illustrates the scientific instrument of Figure 1 while operating to image a sample in a reflection imaging mode;
Figure 3 illustrates a variant of the scientific instrument of Figure 1 while operating to image a sample in a transmission imaging mode;
Figure 4 illustrates a detailed top view of a cold finger of the cooling arrangement interacting with a sample holder;
Figures 5 illustrates a side elevation view of the sample holder approaching the cold finger;
Figure 6 illustrates a side elevation view of the sample holder in direct mechanical contact with the cold finger; and
Figure 7 illustrates a method of operating the scientific instrument.

### SPECIFIC DESCRIPTION

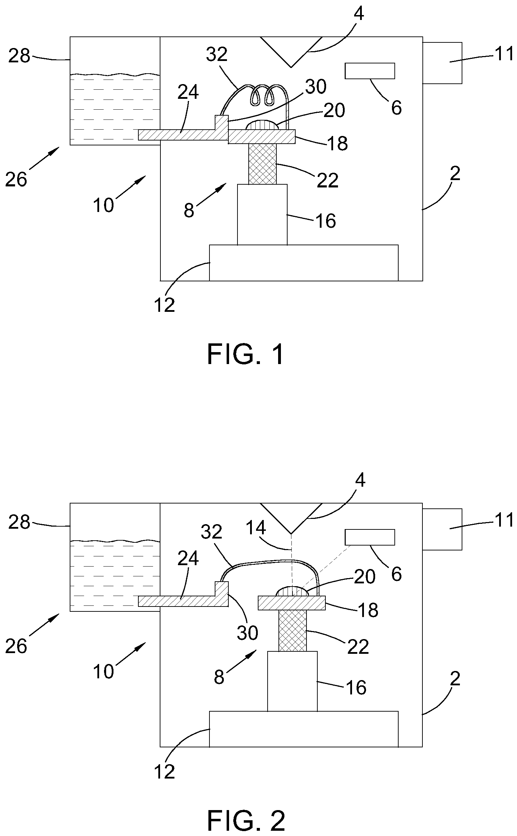

With reference to Figures 1 and 2, a disclosed electron microscope comprises a vacuum chamber 2 and an electron beam source 4, detector 6, sample stage 8 and cooling arrangement 10. It will be appreciated that while a specific case of an electron microscope is described, the disclosure is equally applicable to any charged particle beam microscope or scientific instrument in general. In this general case any one of the vacuum chamber 2, beam source 4 or detector 6 may or may not be present and/or the vacuum chamber 2 may be any other type of chamber, for example at atmospheric pressure. The disclosure is not concerned with the imaging operation of the electron microscope, which is conventional and well known to the person skilled in the art. A controller 11 is connected to the components of the electron microscope and is configured to control operation of the electron microscope, for example as disclosed below.

The sample stage 8 is mounted on a base 12 housing a drive mechanism for moving the sample stage 8 between a parked position as illustrated in Figure 1 and an imaging position in which the sample can be imaged with an electron beam 14, as illustrated in Figure 2. The sample stage 8 comprises a sub-stage 16 secured to the drive mechanism in the base 12 and a sample holder 18 for holding a sample 20. The sample holder 18 is secured to the sub-stage 16 by an insulating member 22. The sample holder is made from or comprises a thermally conductive material, for example a metal, such as copper, to ensure heat transfer to the sample 20. The insulating member 20 is made from or comprises a thermal insulator, for example a polymer, to thermally insulate the sample holder 18 from the sub-stage 16.

The cooling arrangement 10 comprises a cold finger 24 in the form of an elongate thermally conductive member, for example made from or comprising a metal, such as copper, connected to heat sink 26, for example a Dewar 28 filled with a suitably cold fluid, such as liquid nitrogen or helium, with the cold finger 24 in contact with the fluid inside the Dewar 28. The cold finger 24 comprises a cooling plate 30 for directly contacting the sample holder 18 when the sample stage 8 is in the parked position, for example making direct mechanical contact with the sample holder 18, to enable heat transfer via the cooling plate 30 to the sample holder 18.

The cold finger 24 is further thermally connected to the sample holder 18 by a flexible thermally conductive member 32, for example a conductive braid or other flexible thermally conductive member, such as a foil, made from or comprising a metal, such as copper, to enable cooling of the sample holder 18 via the flexible thermally conductive member 32. The flexible member 32 is configured so that sample stage 8 can move away from its parked position, for example to an imaging position as described below with reference to Figure 2. For example, the flexible member 32 may be dimensioned and be sufficiently flexible, for example be sufficiently thin, to enable a desired range of movement of the sample stage 8 without undue mechanical interference or influence on the sample holder 18.

The thermally conductive member 32 is illustrated in Figures 1 and 2 as being directly connected to the sample stage, but it will be appreciated that the disclosure is not so limited and the member may, for example, be connected to a different portion of the sample stage 8, such as the sub-stage 16, with a further, for example less flexible or rigid thermal connection to the sample holder 18 to thermally connect the cold finger 24 to the sample holder 18 via the flexible member 32.

Figure 1 depicts the sample stage 8 in a parked position in which the cooling plate 30 is in contact with the sample holder 18, cooling the sample holder through the cooling plate 30 at a first rate, and also through the flexible member 32 at a second rate. Figure 2 depicts the sample stage 8 in a spaced away position, for example an imaging position in which a sample on the sample holder 18 can be imaged using the beam 14.

The flexible member 32 is configured to enable unimpeded movement between the parking position and imaging position, as well as at the imaging position if sample movement during imaging (or other investigations) is desired. In the imaging position, the sample holder 18 is not in contact with the cooling plate 30 but is still cooled through the flexible member 32 at the second rate. The cooling plate 30 is configured so that the first rate is higher than the second rate, for example by suitable choice of materials and configuration of the cooling plate 30, such as its area of contact with the sample holder 18. The relative higher first rate of cooling enables rapid cooling from, e.g., room temperature to a desired target temperature, while the lower second rate of cooling can be used to maintain the sample 20 at the target temperature.

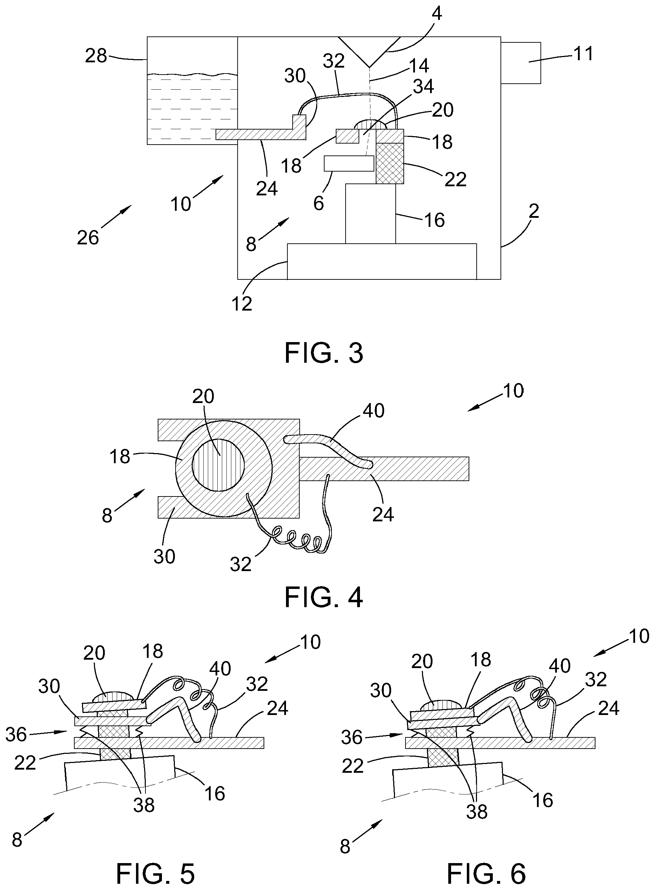

Figure 2 depicts the beam 14 being reflected by the sample 20 to reach the detector 6. With reference to Figure 3, in alternative arrangement, the sample 20 may be imaged or investigated in transmission and the detector 6 is placed accordingly. In these arrangements, the sample holder 18 may comprise an aperture 34 to allow the beam 14 to reach the detector 6 unimpeded. The detector 6 may be disposed so as not to interfere with the movement of the sample stage 8 or may be moveable out of the way of the sample stage 8 to enable movement of the sample stage 8 between the parked and imaging positions.

With reference to Figures 4 to 6, in a specific form of the cooling arrangement 10, the cooling plate 30 is resiliently moveable relative to the cold finger 24. Specifically, the cooling plate 30 is secured to the cold finger 24 by a resilient mount 36, such as a set of one or more springs 38, such as springs made from a suitable metal. An amount of thermal conduction from the cold finger 24 through the cooling plate 30 may be enable by the resilient mount 36, for example through springs 38. In some forms, to enable higher rates of thermal transfer, the cooling plate 30 is further connected to the cold finger 24 by a thermal conductor 40, for example a metal, such as copper, braid, foil or other flexible or malleable plate.

Given the limited amount of movement required for the thermal conductor 40, as compared to the flexible member 32 (not shown in Figures 4 to 6), the thermal conductor can be configured to be relatively thick for improved thermal conductivity. In addition, thermal conductivity is facilitated by the short length required for the thermal conductor 40 to connect the cooling plate 30 to the cold finger 24. As illustrated in Figures 5 and 6, the resilient mount 36 enables the cooling plate 30 to adapt its orientation to the orientation of the sample holder 18 as it contacts the sample holder 18. In this way, close contact of the sample holder 18 with the cooling plate 30 is facilitated for a range of misalignments, providing tolerance in the relative orientation of the cooling arrangement 10 and sample stage 8.

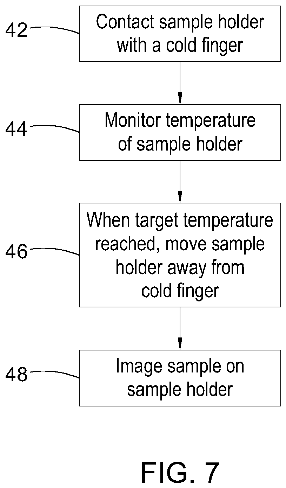

With reference to Figure 7, a method of cooling a sample inside a scientific instrument, such as the electron microscope described above, comprises contacting 42 a sample holder with a cold finger connected to a heat sink to cool the sample holder at a first rate of cooling by bringing the sample holder into mechanical contact with the cold finger, for example with a cooling plate as described above.

While cooling the sample holder in contact with the cold finger, the temperature of the sample holder is monitored 44 until a target temperature is reached. When this happens, the sample holder is moved away 46 from the cold finger to a separate position at which a sample on the sample holder can be investigated, for example imaged. It will be appreciated that instead of the sample holder moving, the cold finger may be moved instead or additionally to make contact with the sample holder for cooling and to move away from the sample holder to dispose the scientific instrument in a configuration for investigation, such as imaging, of the sample.

The sample holder is connected to the cold finger by a flexible thermal connection and cooled at a second rate, less than the first rate, through the flexible thermal connection member when not in direct mechanical contact with the cold finger. When the sample holder is disposed at the separate position (or the instrument is disposed in the imaging configuration, as the case may be), the sample is investigated 48, for example imaged.

The scientific instrument, and specifically the cold finger, sample holder and flexible connection may be configured as described for the electron microscope above and the controller 11 may be configured to implement the described method for cooling the sample.

It is to be understood that the above description is intended to be illustrative, and not restrictive. Many other implementations will be apparent to those of skill in the art upon reading and understanding the above description. Although the present disclosure has been described with reference to specific example implementations, it will be recognized that the disclosure is not limited to the implementations described but can be practiced with modification and alteration within the spirit and scope of the appended claims.

For example, while the sample holder moves to dispose the sample holder and cooling finger relative to each other in the rapid cooling or imaging (or other) configurations, in some embodiments it is the cold finger that moves. For example the cold finger may be attached to a movement stage with at least one degree of freedom. The cold finger may move independently of the remainder of the cooling arrangement, for example being connected to the remainder of the cooling arrangement by a thick flexible braid that enables sufficiently rapid heat transfer, or the cooling arrangement may be configured to move to the cold finger, for example the cooling arrangement moving integrally so that the remainder of the cooling arrangement moves together with the cold finger.

In various embodiments, either one or both of the cold finger and sample holder may move to dispose the cold finger and sample holder in their various relative configurations. Correspondingly either one or both the cold finger and sample holder may be attached to a respective movement stage having at least one degree of freedom. Advantageously, the flexibility of moving either component, or moving both components, enables movement restrictions or volume conflicts in the vacuum chamber (or more generally the sample chamber in non-vacuum embodiments).

The described embodiments use a Dewar filled with a cooling fluid, such as liquid nitrogen or helium, as a heat sink or source of cold. The disclosure is not limited to any particular cold source and alternative cold sources such as Joules-Thompson or Stirling coolers, or even a Pelletier element for less stringent cooling requirement.

Disclosed embodiments are not limited to any specific scientific instrument and may include, for example, any type of charged beam (electron) microscope, or any type of light microscope, for example having any suitable light source, such as an LED or laser light source and corresponding camera, in any suitable wavelength range, for example visible, infrared, far infrared, ultraviolet and the like. An example of a microscope instrument in some embodiments is a confocal microscope.

Accordingly, the specification and drawings are to be regarded in an illustrative sense rather than a restrictive sense. The scope of the disclosure should, therefore, be determined with reference to the appended claims, along with the full scope of equivalents to which such claims are entitled.

## Claims

1. A scientific instrument for investigating a sample, the instrument comprising:
a sample holder;
a cold finger in contact with a heat sink and comprising a cooling plate configured to contact the sample holder to cool the sample holder through the cooling plate;
a thermally conductive flexible member thermally connecting the sample holder and the cold finger to cool the sample holder, wherein the sample holder and cold finger are moveable relative to each other to dispose the sample holder and cold finger in a rapid cooling configuration, in which the cooling plate is in contact with the sample holder, and one or more other configurations for investigating a sample held by the sample holder, in which the cooling plate is not in contact with the sample holder.

2. The scientific instrument of claim 1, comprising a moveable stage, the moveable stage comprising the sample holder and being moveable between a rapid cooling position in which the cooling plate and sample holder are in contact and one or more other positions in which the cooling plate is not in contact with the sample holder.

3. The scientific instrument of any preceding claim, wherein the scientific instrument is a microscope and the one or more other configurations comprise an imaging configuration in which the sample holder is in an imaging, the scientific instrument comprising:
a beam source configured to emit a beam towards the sample holder in the imaging position; and
a beam detector configured to receive a transmitted or reflected beam from the sample holder in the imaging position.

4. The scientific instrument of claim 3, wherein the scientific instrument is a charged particle microscope and the beam is a charged particle beam.

5. The scientific instrument of claim 3, wherein the scientific instrument is an optical microscope and the beam is an electromagnetic beam

6. The scientific instrument of any preceding claim comprising a controller configured to:
monitor a temperature of the sample holder while the sample holder and cooling plate are in the rapid cooling configuration; and,
in response to the temperature reaching a target temperature, move the sample holder and/or cold finger to dispose the sample holder and cold finger in one of the one or more other configurations.

7. The scientific instrument of claim 6, when dependent on claim3, claim 4 or claim 5, wherein the controller is configured to, in response to the temperature reaching a target temperature, dispose the sample holder and cold finger in the imaging configuration.

8. The scientific instrument of any preceding claim, wherein the cooling plate is resiliently mounted on the cold finger to facilitate close contact with the sample holder in a range of orientations.

9. The scientific instrument of any preceding claim, wherein the sample holder is mounted on a base connected to a motorised mechanism for moving the sample holder.

10. The scientific instrument of claim 9, wherein the sample holder is mounted to the base by a thermally insulating member.

11. The scientific instrument of claim 10, wherein the cooling plate comprises a cooling face to contact a face of the sample holder facing the base and an aperture to accommodate the insulating member.

12. The scientific instrument of claim 11, wherein the sample holder is disposed in a sample chamber, the heat sink is disposed outside the sample chamber and the cold finger extends from the heat sink into the sample chamber.

13. A method of cooling a sample disposed on a sample holder thermally connected to a cold finger by a thermally conductive flexible member, the method comprising:
moving the sample holder and/or cold finger to directly contact the sample holder with the cold finger to cool the sample on the sample holder at a first rate of cooling;
monitoring a temperature of the sample holder; and,
in response to the temperature reaching a target temperature, moving the sample holder and/or cold finger to space the sample holder away from the cold finger while continuing to cool the sample using the thermally conductive flexible member at a second rate of cooling lower than the first rate of cooling.

14. The method of claim 14, comprising investigating the sample subsequent to moving the sample holder and/or cold finger to space the sample holder away from the cold finger, while keeping the sample holder at the target temperature.

15. The method of claim 13 or claim 14, comprising moving the sample holder to directly contact the sample holder with the cool finger and to space the sample holder away from the cold finger.
